# EUROPEAN PATENT APPLICATION

(11) **EP 1 744 372 A2**
(43) Date of publication of application: **17.01.2007**
(21) Application number: 06014338.5
(22) Date of filing: 11.07.2006
(51) Int. Cl.: H01L 31/042

(54) **Solar panel**

(30) Priority: 13.07.2005 GB 0514360; 21.10.2005 GB 0521410
(71) Applicant: ZETA CONTROLS LIMITED, Bicester Oxon Oxfordshire 26 4LB (GB)
(72) Inventor: Shadbolt, Philip David, Oxford OX27 8DL (GB); Tyrrell, Paul John, Oxford OX1 5BQ (GB)
(74) Representative: Raynor, Simon Mark

(57) **Abstract**

A solar panel (2) includes a flexible polymeric support element (4) and a plurality of photovoltaic cells (6) supported by the support element. At least some of the photovoltaic cells (6) are spaced apart such that the flexible support element provides a hinge (10) between the spaced apart photovoltaic cells. A plurality of bypass diodes (14) are connected in parallel with the cells (6), so that if one of the cells ceases to operate, electrical current generated by the other cells is able to bypass the inoperative cell.

## Description

The present invention relates to a solar panel. In particular but not exclusively the invention relates in one aspect to a solar panel that is suitable for mounting on a curved surface, and in another aspect to a solar panel that is not excessively affected by reduced or non-operation of one or more solar cells.

Solar panels are sometimes mounted on curved surfaces such as the roofs of bus shelters and are used to generate electricity for lighting, signage and other purposes. In such situations, photovoltaic cells made of amorphous silicon are generally used as they are flexible and can be bent to fit the curved surface. Such photovoltaic cells are however relatively inefficient, generating only about 50% of the power generated by mono- or poly-crystalline photovoltaic cells of the same size. However, mono- and poly-crystalline photovoltaic cells are not flexible and crack easily if bent. They are not suitable therefore for mounting on curved surfaces.

Solar panels generally consist of an array of series-connected photovoltaic cells. A problem with existing solar panels is that if one or more of the cells is damaged or non-operational (for example, if it is shaded from the sunlight), the impedance of that cell will greatly reduced the output of the entire panel.

It is an object of the present invention to provide a solar panel that mitigates at least some of the aforesaid disadvantages.

According to one aspect of the present invention there is provided a solar panel including a flexible polymeric support element and a plurality of photovoltaic cells supported by the support element, wherein at least some of the photovoltaic cells are spaced apart and the flexible support element provides a hinge between the spaced apart photovoltaic cells.

The solar panel according to the invention is able to flex, allowing it to be attached to curved surfaces while using rigid photovoltaic cells. Because the most efficient photovoltaic cells are normally rigid, this allows either maximum power extraction from the available surface area or the use of a smaller panel.

Advantageously, the solar panel includes a plurality of parallel binges, allowing it to be fitted to relatively highly curved cylindrical surfaces without excessively stressing the photovoltaic cells. For ease of installation, the solar panel may be attached to the underlying support surface using adhesive tape or pads.

Advantageously, the solar panel includes a two-dimensional array of photovoltaic cells arranged in parallel rows, with flexible hinges between at least some of the rows. Each row can be made up from a plurality of relatively small, inexpensive cells.

Preferably, each row of cells includes a substrate, which is preferably made of fibre glass on another suitable printed circuit board material, for example paper. The substrate preferably carries the electrical connections between the cells.

The cells are preferably of a mono- or poly-crystalline type. Such cells are highly efficient, particularly in comparison to flexible amorphous photovoltaic cells.

The polymeric support element is preferably made of polyethylene terephthalate (PET), which is durable, UV stable, weatherproof and does not affect the performance of the photovoltaic cells. Other suitable materials may also be used.

Advantageously, the photovoltaic cells are embedded in the polymeric support element. This provides a degree of protection for the photovoltaic cells while not significantly affecting their efficiency.

Advantageously, the photovoltaic cells are connected in series and a plurality of bypass diodes are connected in parallel with the photovoltaic cells, whereby in the event that one or more of the photovoltaic cells ceases to operate, electrical current generated by operation of the other photovoltaic cells is able to bypass the inoperative cells through one or more of the bypass diodes. This arrangement ensures that even if some of the cells are unable to generate efficiently (for example, because they are damaged or shaded from the sun), the generating efficiency of the other cells is not affected.

Advantageously, the bypass diodes are mounted externally of the cells and are preferably embedded in the substrate. This provides a compact, space saving product and does not impede flexing of the panel.

According to another aspect of the invention there is provided a solar panel including a plurality of photovoltaic cells connected in series and a plurality of bypass diodes connected in parallel with the series-connected cells, whereby in the event that one or more of the photovoltaic cells ceases to operate, electrical current generated by operation of the other photovoltaic cells is able to bypass the inoperative cells through one or more of the bypass diodes.

Various embodiments of the present invention will now be described with reference to the accompanying drawings, in which:
Figure 1 is a plan view of a solar panel according to a first embodiment of the invention;
Figure 2 is an end view of the first solar panel;
Figure 3 is a plan view from above of a row of cells forming part of the first solar panel;
Figure 4 is a plan view from below of the row of cells shown in figure 3;
Figure 5 is an enlarged sectional side view on line V-V of figure 3;

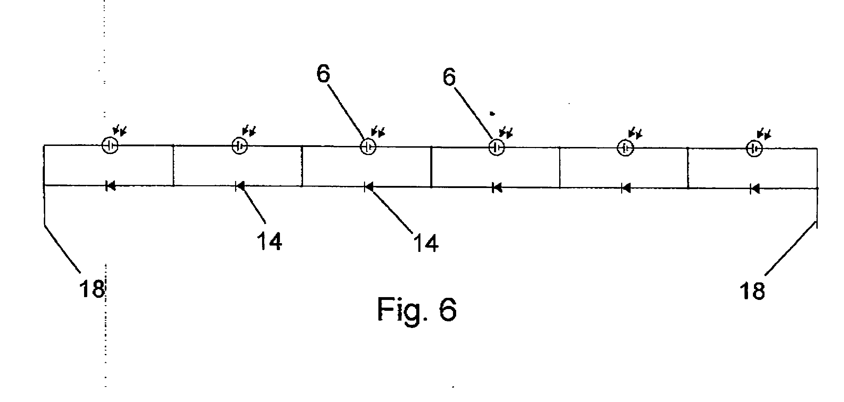

Figure 6 is a circuit diagram of the first solar panel;
Figure 7 is a plan view showing the electrical connections between the cells in the first solar panel;
Figure 8 is a plan view showing the electrical connections between the cells in a solar panel according to a second embodiment of the invention, and
Figure 9 is a plan view showing the electrical connections between the cells in a solar panel according to a third embodiment of the invention.

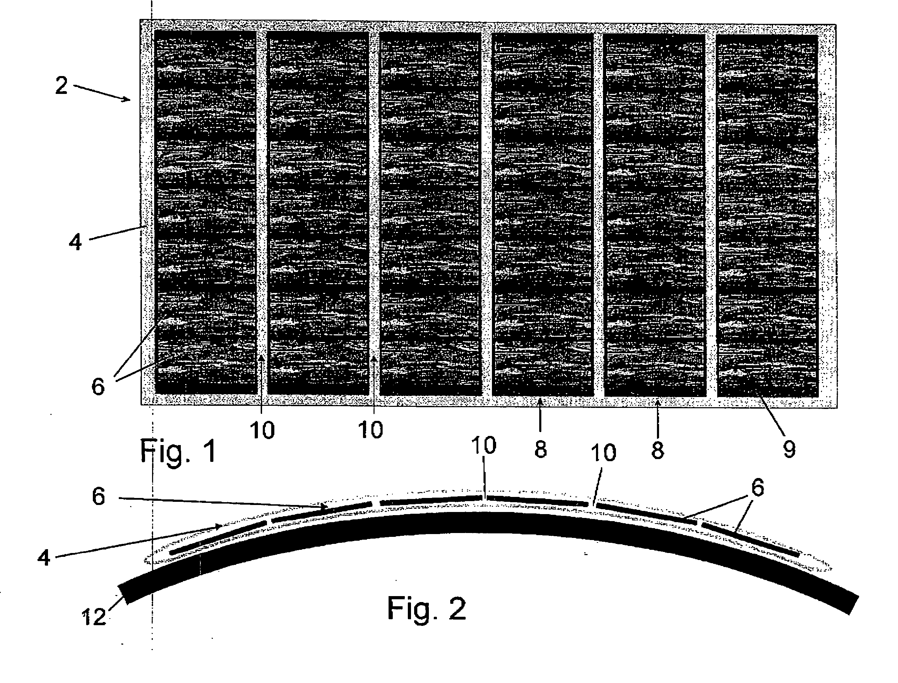

The solar panel 2 shown in figure 1 includes a rectangular support element 4 that is made of a flexible polymeric material, for example PET. The support element supports a two-dimensional array of photovoltaic cells 6, which are embedded within the polymeric material of the support element 4. The cells 6 are arranged in six parallel rows 8, each row containing seven cells on a printed circuit board substrate 9 of fibre glass (e.g. FR4). The PCB substrate 9 carries the electrical connections (not shown) to the cells 6.

The parallel rows of cells 6 are spaced apart with 2mm gaps between adj acent rows 8. The flexible polymeric support element provides a plurality of parallel flexible hinges 10 in the gaps between the spaced apart rows 8. The hinges 10 allow the solar panel 2 to flex without excessively bending or stressing the individual cells 6. This allows the panel 2 to be mounted on a curved mounting surface 12, for example the roof of a bus shelter, as shown in figure 2. We have found that a panel as shown in figure 1 with dimensions of 700mm by 395mm can easily flex around a curvature of 180° without damaging the cells. The solar panel may be attached to the underlying support surface using adhesive tape or pads (not shown), or by any other suitable method.

The cells 6 are made of a mono- or poly-crystalline semi-conductor material. Each cell has an optimum output voltage of 0.5V. Each row 8 consists of seven series-connected cells and has an optimum output voltage of 3.5V and generates an output power of 5W. The panel 2 comprises six rows of cells and has an optimum output power of 30W.

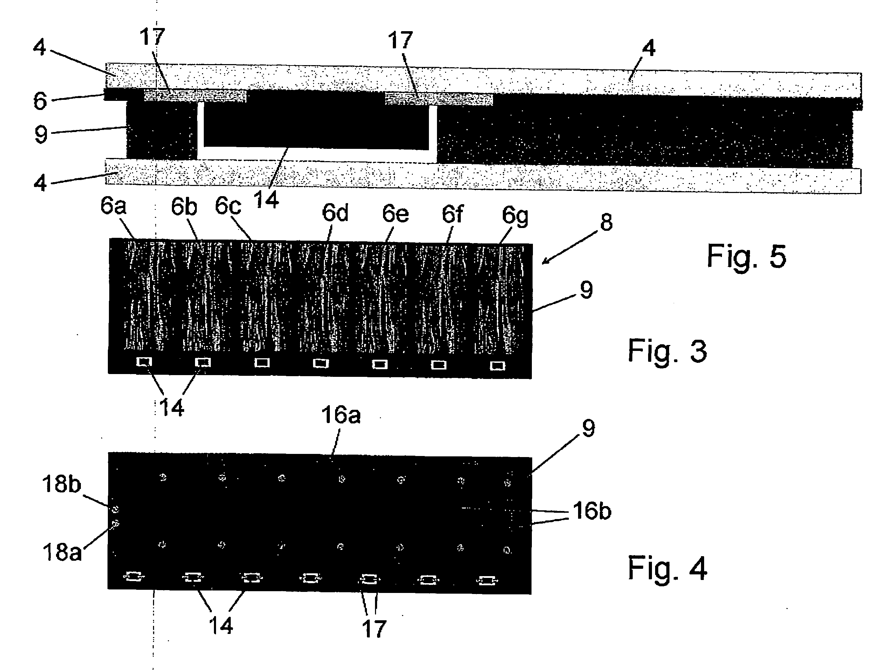

The construction of the solar panel is shown in more detail in figures 3 to 5. Figure 3 is a plan view from above of a row of cells forming part of the solar panel. The row 8 consists of seven cells 6a-6g that are mounted on a PCB substrate 9. The cells 6 are connected in series by a set of interconnectors (not shown) that connect the top surface of the first cell 6a to the bottom surface of the second cell 6b, the top surface of the second cell 6b to the bottom surface of the third cell 6c, and so on. The PCB substrate 9 also carries a set of bypass diodes 14 that are embedded in the substrate alongside each of the cells 6, as shown in figure 5.

On the reverse side of the PCB substrate 9 a circuit of printed connection elements 16a-16b is provided as shown in figure 4, which connect the cells 6 to a pair of output terminals 18a, 18b. The first cell 6a is connected directly to the first output terminal 18a and the last cell 6g is connected to the second output terminal 18b via a first connector element 16a. The circuit is completed by the interconnectors (not shown) that connect the cells 6 in series. A set of second connectors 16b connect the cells 6 to one another through the diodes 14, via diode connectors 17.

A circuit diagram of a row of cells from the solar panel is shown in figure 3. In this embodiment, the photovoltaic cells 6 are connected to one another in series. A bypass diode 14 is connected in parallel with each photovoltaic cell 6. The bypass diode 14 has a lower impedance than the cell 6. If one or more of the photovoltaic cells 6 cease to operate, for example because the cell is damaged or if it is shaded from the sunlight, electrical current generated by operation of the other photovoltaic cells bypasses the inoperative cell through the associated bypass diode 14. This ensures that the performance of the solar panel is not excessively affected by reduced or non-operation of one or more of the cells 6.

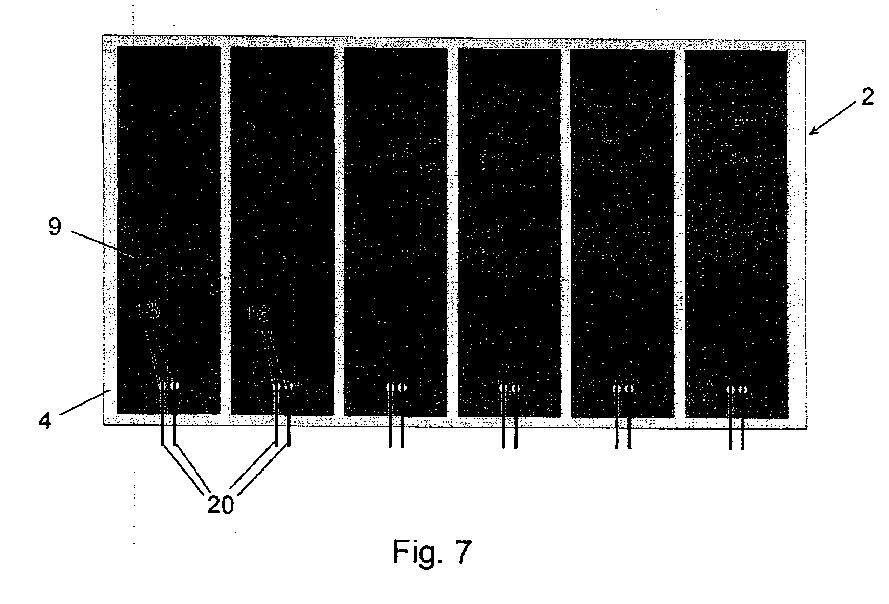

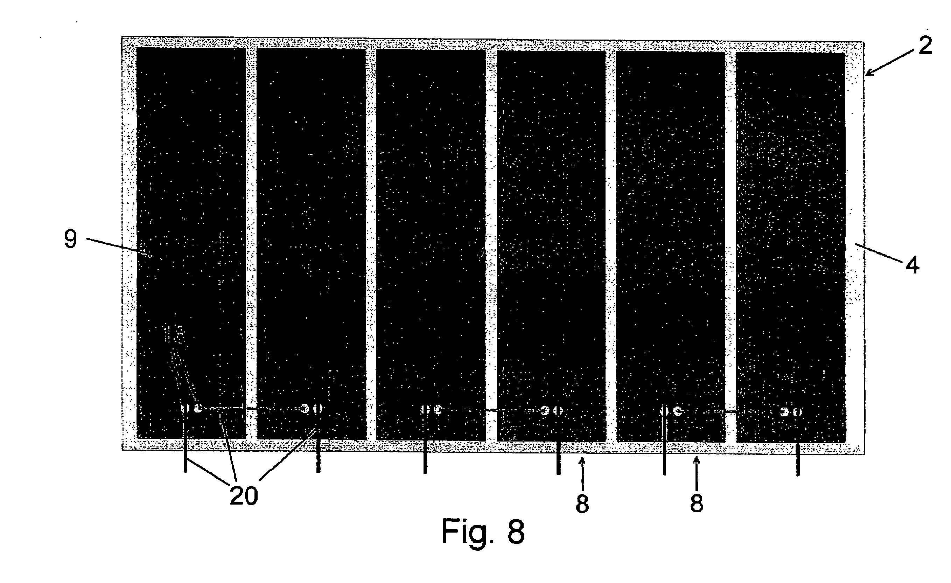

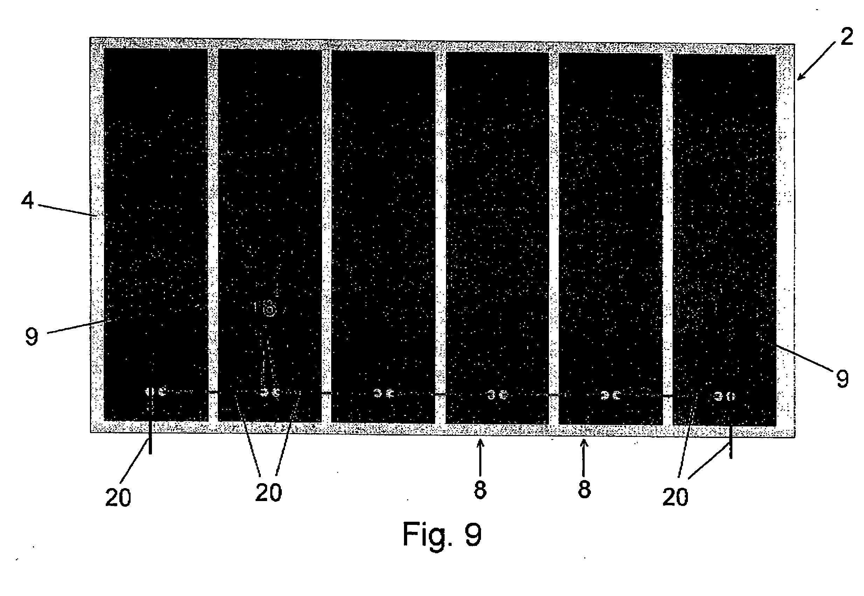

As illustrated in figure 7, output terminals 18 for each row of cells are provided towards one end of the substrate 9. The rows 8 may be interconnected in various different configurations, according to the requirements of the application for which the solar panel 2 is to be used. For example, separate connectors 20 can be connected to each of the rows 8 to provide effectively six 5 W panels. Alternatively, the rows 8 can be connected in pairs as shown in figure 8 to provide three 10W panels, or they can be connected in series as shown in figure 9 to provide a single 30W panel. Other configurations are of course possible.

## Claims

1. A solar panel including a flexible polymeric support element and a plurality of photovoltaic cells supported by the support element, wherein at least some of the photovoltaic cells are spaced apart and the flexible support element provides a hinge between the spaced apart photovoltaic cells.

2. A solar panel according to claim 1, including a plurality of parallel hinges.

3. A solar panel according to claim 1 or claim 2, including a two-dimensional array of photovoltaic cells arranged in parallel rows, with flexible hinges between at least some of the rows.

4. A solar panel according to claim 3, in which each row of cells includes a substrate.

5. A solar panel according to claim 4, in which the substrate carries electrical connector elements for the cells.

6. A solar panel according to any one of the preceding claims, in which the cells are of a mono- or poly-crystalline type.

7. A solar panel according to any one of the preceding claims, in which the polymeric support element is made of PET.

8. A solar panel according to any one of the preceding claims, in which the photovoltaic cells are embedded in the polymeric support element.

9. A solar panel according to any one of the preceding claims, in which the photovoltaic cells are connected in series and a plurality of bypass diodes connected in parallel with the photovoltaic cells, whereby in the event that one or more of the photovoltaic cells ceases to operate, electrical current generated by operation of the other photovoltaic cells is able to bypass the inoperative cells through one or more of the bypass diodes.

10. A solar panel according to claim 9, in which the bypass diodes are provided externally of the photovoltaic cells.

11. A solar panel according to claim 9 or claim 10, in which each row of cells includes a substrate and the bypass diodes are embedded in the substrate.

12. A solar panel including a plurality of photovoltaic cells connected in series and a plurality of bypass diodes connected in parallel with the series-connected cells, whereby in the event that one or more of the photovoltaic cells ceases to operate, electrical current generated by operation of the other photovoltaic cells is able to bypass the inoperative cells through one or more of the bypass diodes.

13. A solar panel according to claim 12, in which the bypass diodes are provided externally of the photovoltaic cells.

14. A solar panel according to claim 12 or claim 13, in which the cells are mounted on a substrate and the bypass diodes are embedded in the substrate.

15. A solar panel according to claim 14, in which the substrate carries electrical connector elements for the cells.
